# EUROPEAN PATENT SPECIFICATION

(11) **EP 3 104 169 B1**
(45) Date of publication and mention of the grant of the patent: **23.09.2020**
(21) Application number: 15746374.6
(22) Date of filing: 27.01.2015
(51) Int. Cl.: H05K 13/08, H05K 3/34, H05K 13/04, G01N 21/956, G01N 23/04, G01B 15/00, G01B 11/00, G01B 11/24, H05K 1/02

(54) **QUALITY MANAGEMENT SYSTEM**
QUALITÄTSMANAGEMENTSYSTEM
SYSTÈME DE GESTION DE QUALITÉ

(30) Priority: 06.02.2014 JP 2014021287
(43) Date of publication of application: 14.12.2016
(73) Proprietor: Omron Corporation, Kyoto-shi, Kyoto 600-8530 (JP)
(72) Inventor: MORI Hiroyuki, Kyoto-shi Kyoto 600-8530 (JP); NISHI Takayuki, Kyoto-shi Kyoto 600-8530 (JP)
(74) Representative: Kilian Kilian & Partner
(86) International application number: PCT/JP2015/052211
(87) International publication number: WO 2015/118997

(56) References cited:
- EP-A2- 2 477 469
- WO-A1-2012/096003
- DE-T5-112011 104 725
- JP-A- H0 372 204
- JP-A- H07 321 492
- JP-A- H09 321 500
- JP-A- 2006 010 429
- JP-A- 2006 237 236
- JP-A- 2007 078 533
- US-A1- 2002 083 570

## Description

### FIELD

The present invention relates to a system for inspecting the state of a component mounted on a printed circuit board.

### BACKGROUND

Surface mounting is a method for mounting a component onto a printed circuit board. With surface mounting, solder paste is applied to a printed circuit board, and a component to be mounted is placed on the circuit board, and the circuit board is heated to melt the solder and fix the component. An apparatus for automatically mounting components onto a printed circuit board often uses surface mounting, which allows fabrication of circuit boards with a high degree of integration.

Automated mounting of components onto a circuit board involves inspections as to whether each component is mounted in place on the circuit board after the solder is cooled (hereafter, postreflow inspection). Accurately determining whether a terminal of a component and an electrode (land) on the circuit board are accurately joined together by solder is important in ensuring the quality of the product.

The postreflow inspection needs accurately detecting each component on the circuit board as well as its position on the circuit board. As one technique for this, Patent Literature 1 describes a component mounting system in which a mounter for mounting a component onto a circuit board transmits information about the dimensions of the component to an inspection apparatus for inspecting the state of the joint of the component, and the inspection apparatus identifies the position to be inspected based on the received information. In this system, the inspection apparatus can accurately identify the size of each component, despite the size variations among individual components.

Patent Literature 2 describes a method for detecting a mounted component and inspecting the component using an optimum inspection library selected for the component.

Further prior art documents are DE 112011104725 T5, EP 2477469 A2 and US 2002/083570 A1.

In more concrete terms, DE 112011104725 T5 discloses a solder-printing inspection device which measures the volume of solder paste on a land on a PCB, and a solder-attachment inspection device which measures the wetting height of the solder after reflow. Said solder-attachment inspection device contains: an inspection program which contains a plurality of evaluation criteria for evaluating the measured wetting height; and a selection rule for selecting from said evaluation criteria. Said selection rule defines which evaluation criterion to select depending on the volume of solder paste on the solder site being inspected, as measured by the solder-printing inspection device. The solder-printing inspection device reads, from an inspection-data management device, the solder-paste volume corresponding to the solder site being inspected and determines the aforementioned evaluation criterion on the basis thereof.

### CITATION LIST

### PATENT LITERATURE

Patent Literature 1: Japanese Unexamined Patent Application Publication No. 2011-91181
Patent Literature 2: Japanese Unexamined Patent Application Publication No. 2004-151057

### SUMMARY

### TECHNICAL PROBLEM

Inspecting the state of a joint between a terminal of a component and an electrode (land) on a circuit board needs accurately determining the position of the component on the circuit board and the position of the terminal end of the component. The position of the terminal end determined inaccurately can cause inaccurate determination of the state of the solder fillet and the solder wetting on the terminal. The position of the terminal end can be detected by, for example, capturing an image of the joint between the terminal and the land and analyzing the captured image.

When, for example, the terminal is completely buried in the solder, or the terminal has its top surface smoothly connecting to the solder, the boundary between the terminal and the solder may be difficult to detect. This can occur, for example, to two-pin mini-mold components, transistors, and some small outline package (SOP) components.

In a conventional surface mounting line, a failure to identify the position of the terminal end may cause inaccurate determination of the state of the solder joint. As a result, an acceptable article can be determined as a defective article.

The component mounting system described in Patent Literature 1 can identify the mounting position of a component on a printed circuit board based on actual measurements, but cannot detect the position of a terminal end. The method described in Patent Literature 2 can detect a component and select an optimum inspection library for the component, but cannot also detect the position of a terminal end.

The position of the terminal end may be estimated from the position of the detected component. However, the terminal end may not always be at an estimated position due to manufacturing variations in the terminal position and its length.

In response to the above issue, it is an object of the present invention to provide a technique for improving the determination accuracy in inspecting the state of a solder joint in a surface mounting line.

This object is achieved by the subject matter of claim 1. Further advantageous embodiments of the invention are the subject matter of the dependent claims. Aspects of the invention are set out below.

A first aspect of the present invention provides a quality management system for a surface mounting line including a solder printing process of printing solder on a printed circuit board using a solder printing apparatus, a mounting process of mounting an electronic component on the printed circuit board using a mounter, and a reflow process of joining the electronic component with the solder using a reflow furnace.

The quality management system according to the aspect of the present invention includes a terminal detection apparatus and a mount inspection apparatus. The terminal detection apparatus generates terminal information after the mounting process. The terminal information is information about a position of a terminal of the electronic component mounted on the printed circuit board. The mount inspection apparatus identifies the position of the terminal of the electronic component based on the terminal information after the reflow process, and inspects a state of a solder joint between the terminal and the printed circuit board.

The terminal detection apparatus generates terminal information after the electronic component is mounted on the printed circuit board. The terminal information is information about the position of the terminal of the mounted electronic component. The terminal information may be any information that can be used by the mount inspection apparatus to identify the position of the terminal on the circuit board. For example, the terminal information may be information indicating the position of the terminal relative to the component, or may include information indicating the width, the length, or the arrangement angle of the terminal.

The mount inspection apparatus inspects the state of the joint between the terminal of the electronic component and the electrode (land) on the printed circuit board after the reflow process. The mount inspection apparatus also identifies the position of the terminal to be inspected on the printed circuit board based on the terminal information generated by the terminal inspection apparatus.

This structure allows the mount inspection apparatus to accurately identify the position of the terminal to be inspected on the circuit board, and to accurately determine the state of the joint between the terminal and the land when the terminal end is buried in the solder.

The terminal detection apparatus may capture an image of the electronic component mounted on the printed circuit board and detect an area including the terminal based on luminance values of pixels included in the captured image.

When the component is illuminated with light, the light reflected by the terminal and the light reflected by the solder have different characteristics. More specifically, the terminal regularly reflects light, whereas the printed solder irregularly reflects light. The terminal detection apparatus can thus identify the position of the terminal by optically detecting such different characteristics and detecting the boundary between the terminal and the solder.

The terminal information may be information indicating a positional relationship of the terminal relative to a reference position set on the electronic component to be inspected.

The reference position is the position that serves as a reference for identifying the position of the terminal. The reference position may be any position commonly used by the terminal detection apparatus and the mount inspection apparatus. The reference position may be, for example, the position of a point set on a component, or may be an edge of a component. The mount inspection apparatus can identify the position of the terminal using the reference position and the information indicating the position of the terminal relative to the reference position.

The terminal information may include information indicating a position of the terminal relative to the reference position, a width of the terminal, and a length of the terminal.

The width and the length of the terminal may be defined in addition to the position of the terminal relative to the reference position. This allows the mount inspection apparatus to identify an area including the terminal to be inspected.

The terminal detection apparatus may be at least any one of the mounter that mounts the electronic component on the printed circuit board, and a component inspection apparatus that inspects an arrangement state of the electronic component on the printed circuit board.

After the component is mounted, the terminal information may be generated by the apparatus that mounts the component, or by the apparatus that inspects the mounting state of the component.

The mount inspection apparatus may be at least any one of an appearance inspection apparatus that inspects a state of a solder joint between an electrode on the printed circuit board and a terminal of the electronic component by using a visible light image, and an internal inspection apparatus that inspects the state of the solder joint between the electrode on the printed circuit board and the terminal of the electronic component by using a non-visible-light image.

As described above, the mount inspection apparatus may be an apparatus that performs an inspection using a visible light image or may be an apparatus that performs an inspection using an image other than a visible light image, such as an X-ray image.

Other aspects of the present invention provide a quality management system including at least some of the above components, a control method for the quality management system, a program for operating the quality management system, and a storage medium storing the program.

The processes and components described above may be combined freely when such combinations do not cause technical conflicts between them.

### ADVANTAGEOUS EFFECTS

The aspects of the present invention improve the accuracy of the inspection determination for the state of a solder joint in a surface mounting line.

### BRIEF DESCRIPTION OF THE DRAWINGS

Fig. 1 is a diagram describing a procedure for producing and inspecting a circuit board with a reflow technique.
Fig. 2 is a diagram showing an overview of an inspection according to an embodiment.
Fig. 3 is a diagram describing determination of the state of a solder joint.
Figs. 4A to 4C are diagrams describing examples in which the state of a joint cannot be determined accurately.
Fig. 5 shows the data structure of inspection object information delivered to an inspection apparatus.
Fig. 6 is a diagram describing a method for identifying an area including a component.
Fig. 7 is a diagram describing a method for identifying an area including a terminal.
Fig. 8 shows an example arrangement of an illumination device and a camera in a component inspection apparatus.
Fig. 9 shows the data structure of terminal information generated by the component inspection apparatus.
Fig. 10 is a flowchart showing an operation performed by the component inspection apparatus.
Fig. 11 is a flowchart showing an operation performed by an appearance inspection apparatus and an X-ray inspection apparatus.
Fig. 12 is a diagram describing another method for identifying an area including a terminal.

### DETAILED DESCRIPTION

### System Configuration

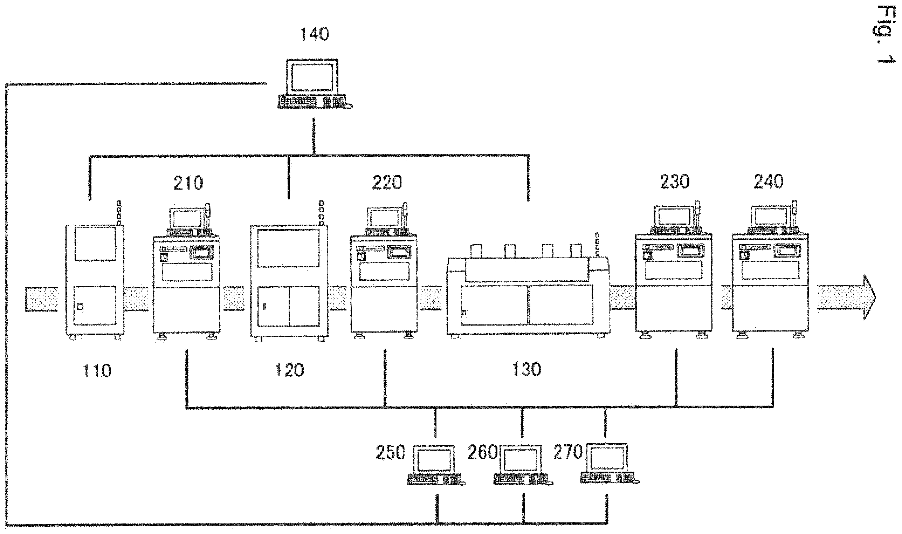

Fig. 1 schematically shows the configuration of production facilities and a quality control system used in a surface mounting line for printed circuit boards in one embodiment. Surface-mount technology (SMT) is a method for soldering an electronic component onto the surface of a printed circuit board. The surface mounting line includes three main processes: solder printing, component mounting, and reflow (solder melting).

As shown in Fig. 1, the surface mounting line includes production facilities including a solder printing apparatus 110, a mounter 120, and a reflow furnace 130 installed in this order from upstream. The solder printing apparatus 110 prints pasty solder onto electrode areas (lands) on a printed circuit board by screen printing. The mounter 120, which is also called a chip mounter, picks up an electronic component to be mounted on the circuit board, and places the component in the corresponding solder paste area. The reflow furnace 130, which is a heater, heats the workpiece to melt the solder paste and then cools it to solder the electronic component onto the circuit board. These production facilities 110 to 130 are connected to a production facility management apparatus 140 via a network (LAN). The production facility management apparatus 140 is a system responsible for the management and centralized control of the production facilities 110 to 130. The production facility management apparatus 140 stores, manages, and outputs a mounting program (including an operational procedure, manufacturing conditions, and setting parameters) defining the operation of each production facility, log data for each production facility, and other data. When receiving an instruction to change a mounting program from an operator or another apparatus, the production facility management apparatus 140 updates the mounting program installed in the corresponding production facility.

The surface mounting line also includes the quality control system for inspecting the state of the circuit board at the end of each process of solder printing, component mounting, and reflow, and automatically detects a defective article or a suspected defective article. In addition to such automated sorting of acceptable articles and defective articles, the quality control system provides inspection results and their analysis results as feedback to the operations of the production facilities (by, for example, changing the mounting program).

As shown in Fig. 1, the quality control system according to the present embodiment includes four inspection apparatuses: a printed solder inspection apparatus 210, a component inspection apparatus 220, an appearance inspection apparatus 230, and an X-ray inspection apparatus 240. The quality control system also includes an inspection management apparatus 250, an analyzer 260, and a workstation 270.

The printed solder inspection apparatus 210 inspects the state of the printed solder paste on the circuit board fed from the solder printing apparatus 110. The printed solder inspection apparatus 210 measures the solder paste printed on the circuit board in a two-dimensional or three-dimensional manner, and determines whether various inspection items for the solder paste fall within the range of normal values (tolerances) based on the measurement results. The inspection items include the volume, area, height, positional deviation, and shape of the solder. The solder paste is two-dimensionally measured with, for example, an image sensor (camera), and three-dimensionally measured with, for example, a laser displacement meter, a phase shifting method, a space-coding method, and a light-section method.

The component inspection apparatus 220 inspects the arrangement of electronic components on the circuit board fed from the mounter 120. The component inspection apparatus 220 measures a component placed on the solder paste (which may be the component body or a part of the component such as an electrode, or a lead) in a two-dimensional or three-dimensional manner, and determines whether various inspection items for the component fall within the range of normal values (tolerances) based on the measurement results. The inspection items include a component positional deviation, a component angular (rotational) deviation, a missing component (no component being placed), a component mix-up (a different component being placed), different polarities (the polarity of the component different from the polarity of the circuit board), a reversal (a component being placed upside down), and a component height. In the same manner as in the solder printing inspection, the electronic component is two-dimensionally measured with, for example, an image sensor (camera), and three-dimensionally measured with, for example, a laser displacement meter, a phase shifting method, a space-coding method, and a light-section method.

The appearance inspection apparatus 230 inspects the state of solder joints on the circuit board fed from the reflow furnace 130. The appearance inspection apparatus 230 measures the postreflow solder in a two-dimensional or three-dimensional manner, and determines whether various inspection items for the solder joints fall within the range of normal values (tolerances) based on the measurement results. The inspection items include the quality of a solder fillet shape in addition to the items used in the component inspection. The shape of solder is determined with, for example, a laser displacement meter, a phase shifting method, a space-coding method, and a light-section method described above, and also with the color highlight system (a method for detecting the three-dimensional shape of solder with two-dimensional hue information by illuminating the solder surface with RGB color light at different angles of incidence and capturing the reflected light of each color using a top camera).

The X-ray inspection apparatus 240 (internal inspection apparatus) inspects the state of solder joints on the circuit board using an X-ray image. For example, a multilayer circuit board and a package component, such as a ball grid array (BGA) and a chip size package (CSP), have solder joints hidden under the circuit board or under the component. In this case, the state of the solder cannot be inspected with the appearance inspection apparatus 230 (or with an appearance image). The X-ray inspection apparatus 240 overcomes such weakness of an appearance inspection. The inspection items of the X-ray inspection apparatus 240 include a component positional deviation, a solder height, a solder volume, a solder ball diameter, a back fillet length, and the quality of a solder joint. The X-ray images may be images captured by projecting X-rays, or may be images captured using the computed tomography (CT) scan.

These inspection apparatuses 210 to 240 are connected to the inspection management apparatus 250 via a network (LAN). The inspection management apparatus 250 is a system responsible for the management and centralized control of the inspection apparatuses 210 to 240. The inspection management apparatus 250 stores, manages, and outputs an inspection program (including an inspection procedure, inspection conditions, and setting parameters) defining the operation of each of the inspection apparatuses 210 to 240, the inspection results and log data obtained by the inspection apparatuses 210 to 240, and other data.

The analyzer 260 analyzes the inspection results collected in the inspection management apparatus 250 from the inspection apparatuses 210 to 240 (the inspection result from each process) to predict defects, estimate the cause of defects, and may provide the analysis results as feedback to the production facilities 110 to 130 as appropriate (by, for example, changing the mounting program).

The workstation 270 displays information about, for example, the states of the production facilities 110 to 130, the inspection results from the inspection apparatuses 210 to 240, and the analysis results from the analyzer 260. The workstation 270 also changes (edits) the mounting program or the inspection program in the production facility management apparatus 140 and the inspection management apparatus 250. The workstation 270 also checks the overall operation of the surface mounting line.

The production facility management apparatus 140, the inspection management apparatus 250, and the analyzer 260 may all be general-purpose computer systems each including a central processing unit (CPU), a main storage unit (memory), an auxiliary storage unit (e.g., a hard disk), an input device (e.g., a keyboard, a mouse, a controller, and a touch panel), and a display. Although the apparatuses 140, 250, and 260 may be separate apparatuses, a single computer system may have all the functions of the apparatuses 140, 250, and 260, or a computer included in any one of the production facilities 110 to 130 and the inspection apparatuses 210 to 240 may have all or some of the functions of the apparatuses 140, 250, and 260. Although Fig. 1 shows the separate networks for the production facilities and for the quality control system, any network allowing mutual data communications may be used.

### Embodiments of Quality Control System

Embodiments of the quality control system for the surface mounting line will now be described. The quality control system according to the present embodiment includes the component inspection apparatus 220, the appearance inspection apparatus 230, the X-ray inspection apparatus 240, and the inspection management apparatus 250.

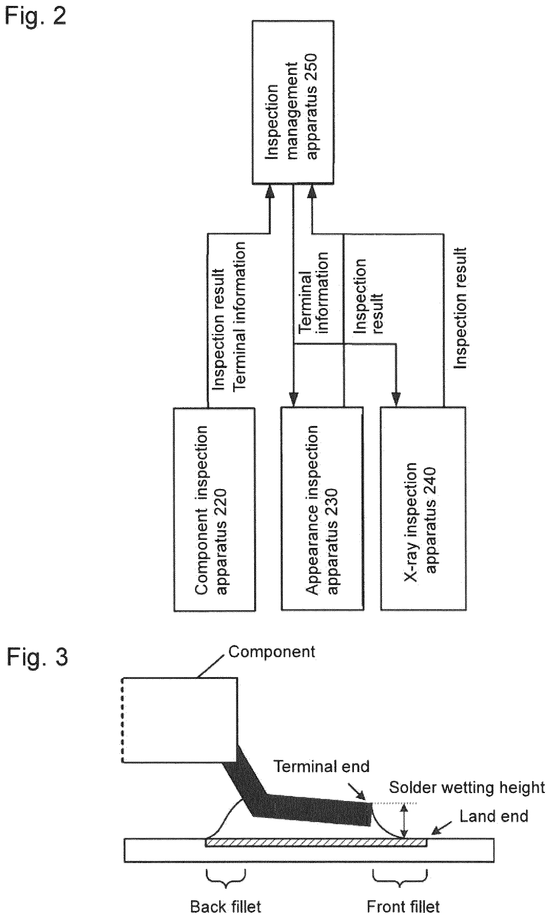

The inspection performed by the quality control system according to the present embodiment will be described in detail with reference to Fig. 2 showing the flow of data.

As described above, the component inspection apparatus 220 inspects whether an electronic component is mounted in place on the circuit board.

The appearance inspection apparatus 230 and the X-ray inspection apparatus 240 use visible light or an X-ray to inspect whether a terminal of the electronic component placed on the circuit board is accurately soldered to the land on the circuit board. In other words, these apparatuses inspect a completed product. A circuit board determined to be defective is sorted as a defective article, and undergoes an additional inspection as appropriate, such as a visual inspection. In this embodiment, inspections performed by the appearance inspection apparatus 230 and the X-ray inspection apparatus 240 are referred to as postreflow inspections.

Each inspection apparatus is installed on the inspection line, and can inspect a circuit board that is transported on the inspection line. Upon the completion of the inspection, each inspection apparatus transmits its inspection result to the inspection management apparatus 250.

Unfortunately, a postreflow inspection can involve an erroneous determination depending on the arrangement of a component and solder. This will be described with reference to Fig. 3, which is a cross-sectional view of a solder joint between a land and a terminal. In Fig. 3, the solid area indicates the terminal, and the hatched area indicates the land.

As shown in Fig. 3, an acceptable solder fillet forms a broad inclined surface, like a mountain slope, from the terminal to the land. An insufficient amount of solder causes a smaller area of the inclined surface, whereas an excess amount of solder causes the fillet to rise on the land. The appearance inspection apparatus 230 and the X-ray inspection apparatus 240 determine the state of the joint based on the shape of the solder.

The state of the joint may be determined based on, for example, the length from the land end to the terminal end, the length of the front fillet, the contact angles of the solder with respect to the land or to the terminal, and the wetting height of the solder. For these determinations, the appearance inspection apparatus 230 and the X-ray inspection apparatus 240 identify the position of the end of the terminal (terminal end) on the circuit board to inspect an appropriate position.

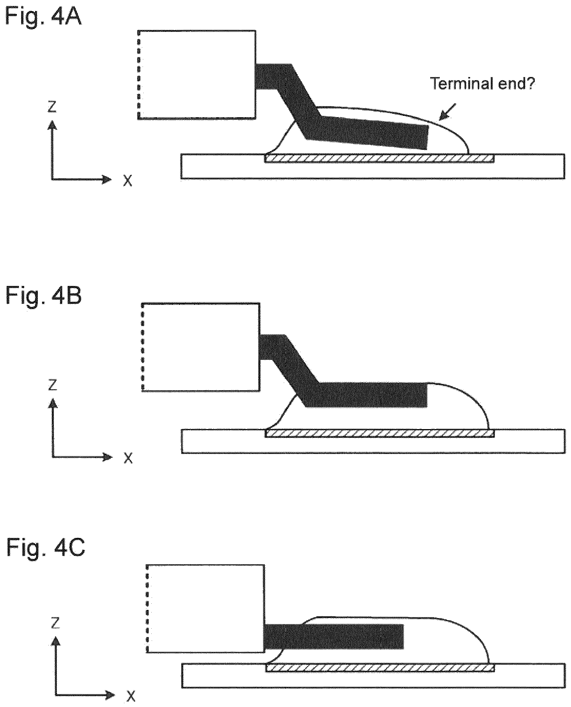

When, for example, the terminal is buried in the solder or the terminal smoothly connects to the solder, the position of the terminal end cannot be identified by appearance. Figs. 4A and 4B show such examples. In the example of Fig. 4A, a gull wing lead is buried in solder, and thus the terminal end cannot be seen from outside. In the example of Fig. 4B, the top surface of the terminal smoothly connects to the solder, and thus the boundary is difficult to detect. In the example of Fig. 4C, a flat lead is buried in solder as in the example of Fig. 4A.

In these cases, the inspection apparatuses face difficulties described below.

### (1) Appearance Inspection Apparatus

The appearance inspection apparatus 230 inspects a component based on the appearance of the component. When the terminal end is hidden, the appearance inspection apparatus 230 estimates the position of the terminal end. The position of the terminal end can be estimated based on, for example, information about the component stored in the inspection apparatus.

However, individual components have differences. The terminal end may not always be at the estimated position. Inspecting an area away from the terminal end by as small as a few micrometers can greatly change the angle and the height of the solder wetting. This may cause an inaccurate determination between an acceptable article and a defective article.

### (2) X-ray Inspection Apparatus

The X-ray inspection apparatus 240 inspects a component by applying an X-ray to the component. When the terminal end is buried, the X-ray inspection apparatus 240 can identify the boundary between the terminal and the solder by detecting a difference between the transmittance of the terminal and the transmittance of the solder. However, this technique uses an additional process for identifying the terminal and the solder, in addition to the process for applying an X-ray. This lengthens the inspection time. To increase the accuracy for identifying the terminal and the solder, this technique uses a clearer image of the boundary. This lengthens the imaging time, and increases the inspection time. If this process is eliminated, the X-ray inspection apparatus will have the same difficulty as the appearance inspection apparatus, or namely may cause an inaccurate determination between an acceptable article and a defective article.

The quality control system according to the present embodiment identifies the position of a terminal with respect to the component body after the mounting process and before the reflow process, and temporarily stores the information about the terminal position, which is used in the postreflow inspection.

For a component inspection, the component inspection apparatus 220 extracts an area including a terminal, generates information indicating the position of the area (hereafter, terminal information), and stores the terminal information together with the inspection result in the inspection management apparatus 250. For a postreflow inspection, the appearance inspection apparatus 230 and the X-ray inspection apparatus 240 obtain the terminal information from the inspection management apparatus 250, and identify the area including the terminal, and then perform the inspection. The processes will be described in detail below.

An overview of the inspection performed by each inspection apparatus will be described first. In the quality control system according to the present embodiment, as described above, the inspection management apparatus 250 delivers an inspection program to each inspection apparatus, which then performs an inspection using the inspection program. The inspection program includes an inspection procedure, as well as information about an object to be inspected (inspection object information).

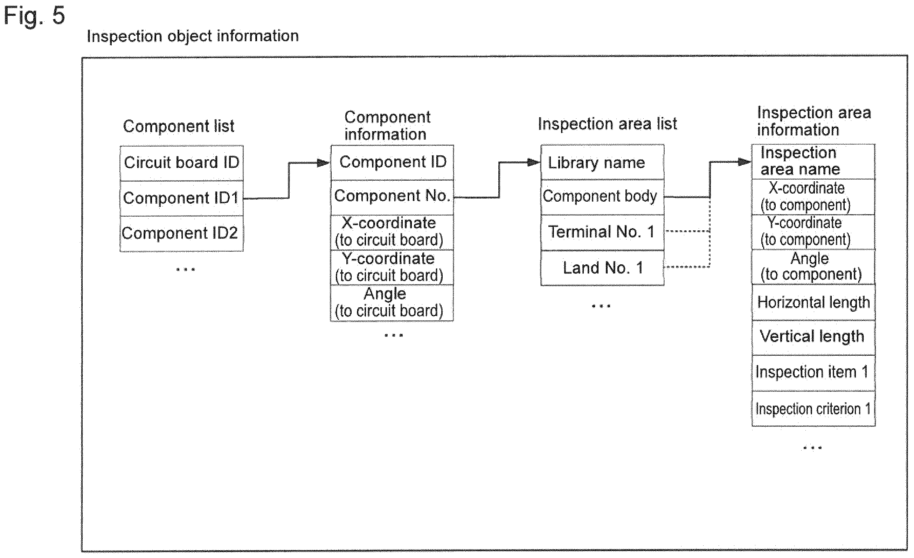

Fig. 5 shows the data structure of inspection object information in one example. The inspection object information includes information about a component to be mounted on the circuit board (component information) and information about the inspection area (inspection area information). The inspection area is a unit for inspection, and may be the component body or a terminal of the component. The inspection area may also be a land to which the terminal is connected. The inspection area information includes information about the position, size, and angle of the inspection object, and further the inspection items and the inspection criteria. Each inspection apparatus performs the inspection by referring to the inspection area information.

Fig. 5 shows information including the coordinates and the angle with respect to the circuit board defined for each component. The information further includes the coordinates and the angle with respect to the component defined for each inspection area. When the inspection area is the component, the coordinates and the angle with respect to the component are 0.

The processing performed by the component inspection apparatus will now be described.

When receiving a printed circuit board, the component inspection apparatus 220 obtains the circuit board ID of the received printed circuit board. The circuit board ID may be obtained from the production facility management apparatus 140, or may be directly read from the circuit board when the ID is readable by capturing an image of the printed circuit board. The component inspection apparatus 220 obtains inspection object information associated with the received printed circuit board from the inspection management apparatus 250, and then performs the component inspection.

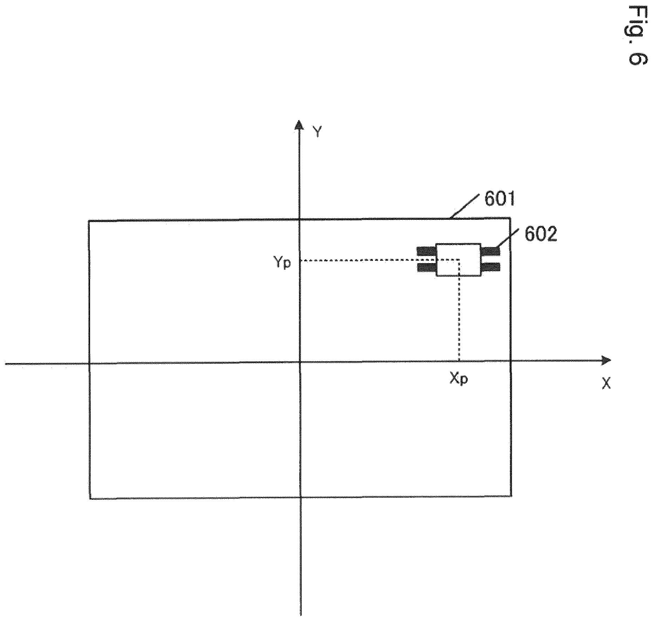

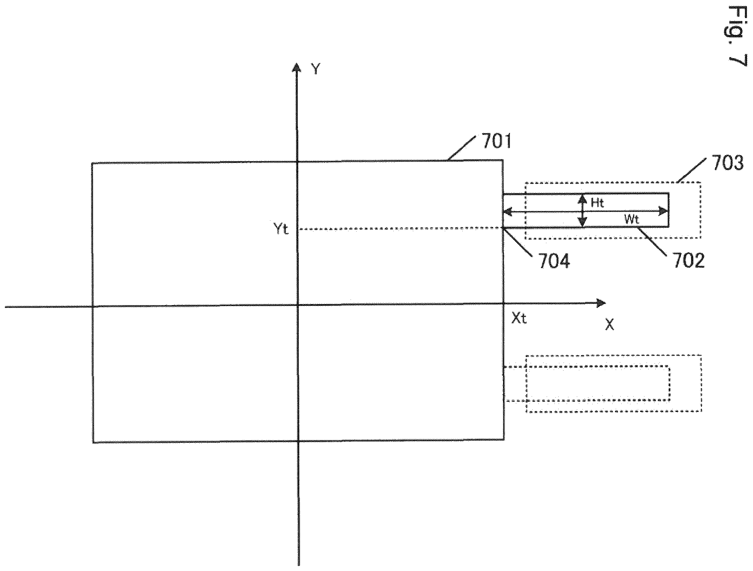

In the component inspection, a component and a terminal in a defined inspection area are inspected. The correspondence between the inspection object information shown in Fig. 5 and the area to be inspected by the inspection apparatus will be described with reference to Figs. 6 and 7.

A method for identifying a component will now be described with reference to Fig. 6. In Fig. 6, the received printed circuit board is indicated by 601, and the area including the component on the printed circuit board is indicated by 602. The X and Y axes shown in Fig. 6 are used to identify the position of the component. The component position is expressed using the XY-coordinate system with the center of the circuit board as the origin (0, 0). For example, the component position indicated by 602 can be expressed using the coordinates (Xp, Yp) of the central point of the component and the angle with respect to the circuit board (e.g., the degree defined counterclockwise with the positive direction of the X-axis as 0 degrees, which is 0 degrees in this example). These parameters correspond to the X-coordinate (to the circuit board), the Y-coordinate (to the circuit board), and the angle (to the circuit board) in the component information shown in Fig. 5. The component information defines the position and the posture of the component placed on the printed circuit board.

A method for identifying an inspection area will now be described with reference to Fig. 7. The position of an inspection area is expressed with respect to the component. In Fig. 7, the component body is indicated by 701, and a terminal of the component is indicated by 702. A land to be connected to the terminal is indicated by 703. The X and Y axes shown the figure are used to identify the terminal position. The terminal position is expressed using the XY-coordinate system with the center of the component as the origin (0, 0). For example, the terminal indicated by 702 can be expressed using the coordinates (Xt, Yt) of the point 704, which is the lower left corner of the terminal, the horizontal length Wt and the vertical length Ht of the component, and the angle with respect to the component (0 degrees). These parameters correspond to the X-coordinate (to the component), the Y-coordinate (to the component), the horizontal length, the vertical length, and the angle (to the component) in the inspection area information shown in Fig. 5.

As described above, the component information and the inspection area information are used to identify the position of the inspection area on the printed circuit board.

The origin set on the circuit board is commonly used by the inspection apparatuses. More specifically, the origin serves as a common reference for expressing a position to uniquely identify an area on the printed circuit board.

The component inspection apparatus inspects whether the component or the terminal to be inspected is located in the defined area (or whether the component is mounted in place). The component inspection apparatus generates an inspection result, and transmits the inspection result to the inspection management apparatus 250.

As described above, individual components and terminals have different sizes. Thus, each printed circuit board on which the same components are mounted can have a positional deviation of an inspection area. A slight deviation may not affect the component inspection, and the inspection can be performed. However, such an error may affect the quality of the postreflow inspection. The component inspection apparatus 220 thus generates terminal information indicating the accurate position of the terminal after the component inspection is complete.

More specifically, an image of a target component captured with a camera is used to identify a terminal and solder, and extract an area including the terminal. The terminal and the solder are identified by, for example, extracting pixels in a particular color space from the captured image.

The terminal before soldering has a smooth surface, which regularly reflects incident light. In contrast, the solder has a non-smooth surface, which irregularly reflects incident light. This can be used to identify the area including the terminal and the other area based on the pixel values (luminance values).

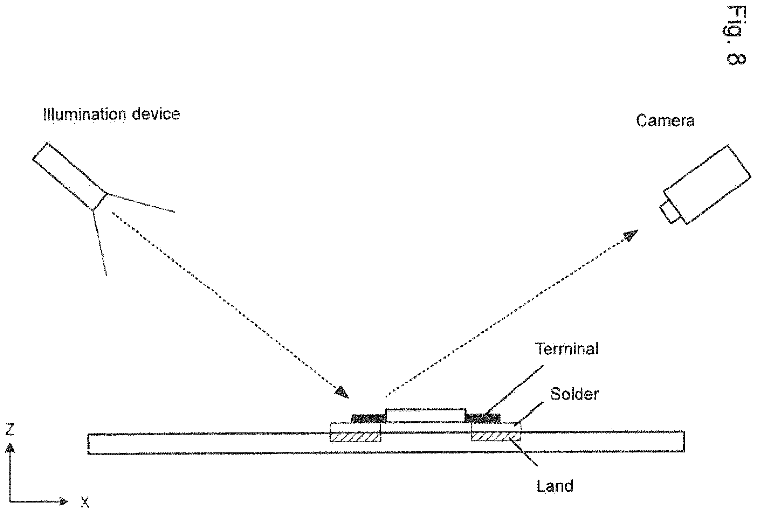

Fig. 8 shows a specific example. When an illumination device for illuminating a component with light and a camera for capturing an image are installed at the same angle as shown in Fig. 8, the intensity of light reflected by the area other than the terminal area is lower than that reflected by the terminal. In this case, the area including the terminal can be estimated by determining whether the luminance values of pixels in the image are not less than a threshold. The position, the length, and the angle of the terminal in the space can also be determined based on the position on the image.

When, for example, the luminance values of the pixels in an image fall within a range of 0 to 255 for each color (a full-color image with 16,777,000 colors) and the threshold is 225 or higher, an area including a terminal can be extracted by selecting pixels with luminance values all within a range of 225 to 255 for each of red, green, and blue. The accurate position of the terminal can also be calculated based on the extraction results. The illumination light, which is white in this example, may be any other color. A threshold may be set for the color of the illumination light.

The parameters for estimating the terminal area (e.g., the thresholds for the R, G, and B luminance values) may be included in the inspection area information, or may be separately stored in the component inspection apparatus. The parameters may not be RGB values but may be other values each defining a predetermined range in the color space.

Although the parameters included in the inspection area information can be defined differently for each terminal, the same parameters are set for a plurality of terminals in the present embodiment. The parameters may be set differently for each terminal.

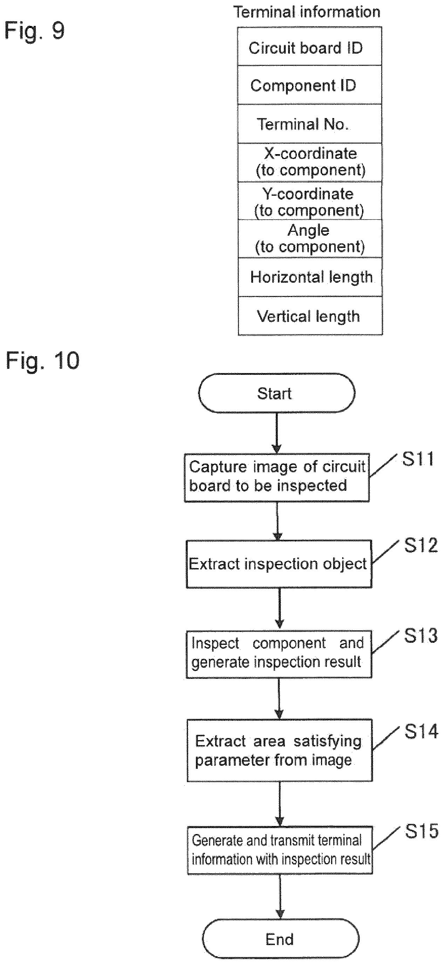

Fig. 9 shows terminal information generated by the component inspection apparatus 220 in one example. The terminal information includes keys for uniquely identifying the terminal (a circuit board ID, a component ID, and a terminal number) and information about the area corresponding to the terminal. The area including the terminal is expressed using the XY-coordinate system in the same manner as in the inspection area information with the center of the component as the origin and a particular direction of the component as the X-axis. The X-coordinate (to the component), the Y-coordinate (to the component), the horizontal length, the vertical length, and the angle (to the component) included in the terminal information shown in Fig. 9 correspond to the same items in the inspection area information shown in Fig. 5. Unlike the items shown in Fig. 5, these items in the terminal information are not values based on the specifications, but are measured values.

The terminal information transmitted to the inspection management apparatus 250 is stored temporarily, and is delivered to the appearance inspection apparatus 230 and the X-ray inspection apparatus 240, together with the inspection program to be used for the postreflow inspection.

When inspecting the state of the joint between the terminal and the land, the appearance inspection apparatus 230 and the X-ray inspection apparatus 240 use the received terminal information to identify the area including the corresponding terminal. The reflow process melts the solder, causing the component to move down in the vertical direction (the Z-axis direction in Fig. 8). This changes the coordinates and the angle of the component in the XY plane. However, the position of the terminal relative to the component body remains unchanged. The postreflow inspection can be performed based on the information obtained before the reflow process.

### Process Flowchart

Fig. 10 is a flowchart showing the inspection process performed by the component inspection apparatus 220. The process shown in Fig. 10 is started when a printed circuit board to be inspected is received. The inspection program is delivered from the inspection management apparatus 250 in advance.

In step S11, an image of the circuit board to be inspected is first captured with the camera. Although the captured image is used to determine the position of a terminal, an additional image may be captured as appropriate for a component inspection. Several images may be captured with different cameras.

In step S12, an inspection object is extracted from the inspection object information included in the inspection program. The extracted inspection object is a component or a terminal.

In step S13, a component inspection for the inspection object is performed to generate an inspection result. The inspection may be performed through two-dimensional measurements or three-dimensional measurements.

In step S14, an image parameter corresponding to the terminal of the inspection object is obtained from the inspection object information, and the area satisfying the image parameter is extracted from the image obtained in step S11. When, for example, the luminance values are in the range of 0 to 255 and the image parameter is a luminance value higher than 225, an area having luminance values in the range of 225 to 255 inclusive is extracted.

In step S15, sets of terminal information for terminals on the circuit board are generated based on the extracted area, and these generated information sets are transmitted to the inspection management apparatus 250, together with the inspection result generated in step S13.

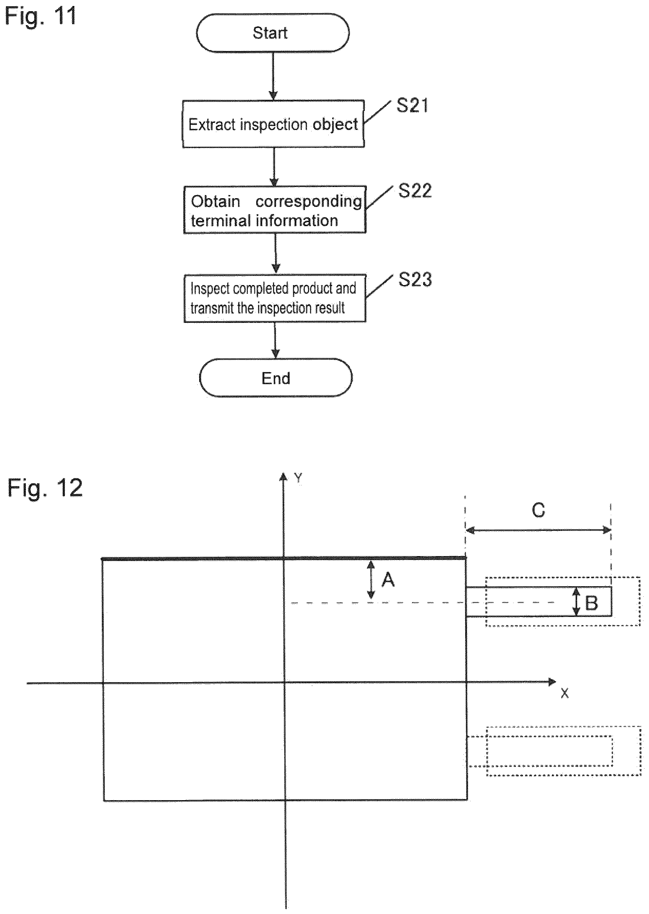

Fig. 11 is a flowchart showing the inspection process performed by the appearance inspection apparatus 230 and the X-ray inspection apparatus 240. This process in Fig. 11 is started when each of the inspection apparatuses receives a printed circuit board and starts the inspection. The inspection program is delivered from the inspection management apparatus 250 in advance.

In step S21, the inspection apparatus first extracts an inspection object from the inspection object information included in the inspection program. The extracted inspection object is a land.

In step S22, the inspection apparatus uses the inspection object information to identify a terminal corresponding to the land to be inspected, and obtains terminal information corresponding to the identified terminal from the inspection management apparatus 250. In this process, the terminal joined to the land as the inspection object is identified. If the inspection apparatus cannot obtain the terminal information corresponding to the land as the inspection object, the inspection apparatus uses the terminal positional information included in the inspection object information to estimate the position of the terminal.

In step S23, the inspection apparatus inspects the land as the inspection object (visual inspection or X-ray inspection). When the inspection is complete, the inspection apparatus generates an inspection result, and transmits the inspection result to the inspection management apparatus 250.

As described above, the quality control system according to the present embodiment detects and stores the position of a terminal before the reflow process, and uses the information to identify the position of the terminal in a postreflow inspection. This allows the position of the terminal to be accurately identified when the terminal and the solder are integrated in the reflow process and are difficult to differentiate from each other. This further improves the accuracy of the postreflow inspection. This structure reduces the number of erroneous determinations of acceptable articles as defective articles, and reduces the inspection cost and improves the productivity.

### Modifications

The above embodiment is a mere example for describing the present invention, and may be modified or combined as appropriate as long as it falls under the scope of the appended claims.

For example, although the area corresponding to the terminal is expressed using the coordinate system with the center of the component as the origin in the above embodiment, the area corresponding to the terminal may be expressed with any method that allows the inspection apparatus to identify the area. Fig. 12 is a diagram describing another method for identifying the area corresponding to the terminal. In the example shown in Fig. 12, one of the side edges of the component is used as a reference side edge (indicated by a bold line). The position of the terminal is defined by a distance A between the reference side edge and the center of the terminal, a width B of the terminal, and a length C of the terminal. Although the terminal position is expressed using the five values in the example shown in Fig. 9, the terminal position may be defined using the three values as in this example when the terminal extends parallel to the component and the reference side edge can be identified among the side edges of the component.

In the above embodiment, the inspection management apparatus 250 collects all the terminal information and then delivers the information to the appearance inspection apparatus 230 and the X-ray inspection apparatus 240. In some embodiments, the terminal information may be directly transmitted and received between the inspection apparatuses.

In the above embodiment, the component inspection apparatus 220 generates the terminal information. In some embodiments, for example, the mounter 120 may generate terminal information that can identify the position of a terminal of a mounted component.

### REFERENCE SIGNS LIST

- 110: solder printing apparatus
- 120: mounter
- 130: reflow furnace
- 140: production facility management apparatus
- 210: printed solder inspection apparatus
- 220: component inspection apparatus
- 230: appearance inspection apparatus
- 240: X-ray inspection apparatus
- 250: inspection management apparatus
- 260: analyzer
- 270: workstation

## Claims

1. A quality management system for a surface mounting line including a solder printing process of printing solder on a printed circuit board using a solder printing apparatus (110), a mounting process of mounting an electronic component on the printed circuit board using a mounter (120), and a reflow process of joining the electronic component with the solder using a reflow furnace (130), the quality management system comprising:
a terminal detection apparatus (220) configured to generate terminal information after the mounting process and before the reflow process by measuring, the terminal information being information about a position of a terminal of the electronic component mounted on the printed circuit board, the terminal information being information indicating a positional relationship of the terminal relative to a reference position set on the electronic component to be inspected; and
a mount inspection apparatus (230, 240) configured to identify the position of the terminal of the electronic component based on the measured terminal information after the reflow process, identify an inspection area based on the identified terminal position, and inspect a state of a solder joint between the terminal and the printed circuit board in the identified inspection area.

2. The quality management system according to claim 1, wherein
the terminal detection apparatus (220) is configured to capture an image of the electronic component mounted on the printed circuit board and detect an area including the terminal based on luminance values of pixels included in the captured image.

3. The quality management system according to claim 1 or 2, wherein
the terminal information includes information indicating a position of the terminal relative to the reference position, a width of the terminal, and a length of the terminal.

4. The quality management system according to any one of claims 1 to 3, wherein
the terminal detection apparatus (220) is at least any one of the mounter (120) configured to mount the electronic component on the printed circuit board, and a component inspection apparatus (220) configured to inspect an arrangement state of the electronic component on the printed circuit board.

5. The quality management system according to any one of claims 1 to 4, wherein
the mount inspection apparatus (230, 240) is at least any one of an appearance inspection apparatus (230) configured to inspect a state of a solder joint between an electrode on the printed circuit board and a terminal of the electronic component by using a visible light image, and an internal inspection apparatus (240) configured to inspect the state of the solder joint between the electrode on the printed circuit board and the terminal of the electronic component by using a non-visible-light image.

## Patentansprüche

1. Qualitätsmanagementsystem für eine Oberflächenmontagelinie mit einem Lötdruckverfahren zum Drucken von Lötmittel auf eine gedruckte Leiterplatte unter Verwendung einer Lötdruckvorrichtung (110), einem Montageverfahren zum Montieren eines elektronischen Bauteils auf der gedruckten Leiterplatte unter Verwendung eines Montagegeräts (120) und einem Aufschmelzverfahren zum Verbinden des elektronischen Bauteils mit dem Lötmittel unter Verwendung eines Aufschmelzofens (130), wobei das Qualitätsmanagementsystem umfasst:
eine Anschlusserfassungsvorrichtung (220), die so konfiguriert ist, dass sie Anschlussinformationen nach dem Montageprozess und vor dem Aufschmelzverfahren erzeugt durch Messen von den Anschlussinformationen, die Informationen über eine Position eines Anschlusses des elektronischen Bauteils sind, das auf der Leiterplatte montiert ist, wobei die Anschlussinformationen Informationen sind, die eine Positionsbeziehung des Anschlusses relativ zu einer Referenzposition anzeigen, die an dem zu prüfenden elektronischen Bauteil eingestellt ist; und
eine Montageüberprüfungsvorrichtung (230, 240), die konfiguriert ist, um die Position des Anschlusses des elektronischen Bauteils auf der Grundlage der gemessenen Anschlussinformationen nach dem Aufschmelzverfahren zu identifizieren, einen Überprüfungsbereich auf der Grundlage der identifizierten Anschlussposition zu identifizieren und einen Zustand einer Lötverbindung zwischen dem Anschluss und der gedruckten Leiterplatte in dem identifizierten Überprüfungsbereich zu inspizieren.

2. Qualitätsmanagementsystem gemäß Anspruch 1, wobei
die Anschlusserfassungsvorrichtung (220) so konfiguriert ist, dass sie ein Bild des auf der Leiterplatte montierten elektronischen Bauteils aufnimmt und einen Bereich einschließlich des Anschlusses auf der Grundlage von Luminanzwerten von Pixeln, die in dem aufgenommenen Bild enthalten sind, erfasst.

3. Qualitätsmanagementsystem gemäß Anspruch 1 oder 2, wobei
die Anschlussinformationen Informationen enthalten, die eine Position des Anschlusses relativ zur Referenzposition, eine Breite des Anschlusses und eine Länge des Anschlusses angeben.

4. Qualitätsmanagementsystem gemäß einem der Ansprüche 1 bis 3, wobei
die Anschlusserfassungsvorrichtung (220) zumindest eine aus der Montagevorrichtung (120), die konfiguriert ist, um die elektronische Komponente auf der gedruckten Leiterplatte zu montieren, und einer Komponentenüberprüfungsvorrichtung (220), die konfiguriert ist, um einen Anordnungszustand der elektronischen Komponente auf der gedruckten Leiterplatte zu prüfen, ist.

5. Qualitätsmanagementsystem gemäß einem der Ansprüche 1 bis 4, wobei
die Montageüberprüfungsvorrichtung (230, 240) mindestens eine aus einer Erscheinungsbildüberprüfungsvorrichtung (230), die konfiguriert ist, um einen Zustand einer Lötverbindung zwischen einer Elektrode auf der gedruckten Leiterplatte und einem Anschluss des elektronischen Bauteils unter Verwendung eines Bildes mit sichtbarem Licht zu überprüfen, und einer internen Überprüfungsvorrichtung (240), die konfiguriert ist, um den Zustand der Lötverbindung zwischen der Elektrode auf der gedruckten Leiterplatte und dem Anschluss des elektronischen Bauteils unter Verwendung eines Bildes mit nicht sichtbarem Licht zu inspizieren, ist.

## Revendications

1. Système de gestion de qualité pour une ligne de montée en surface comportant un procédé d'impression de brasure tendre pour imprimer une brasure tendre sur une carte de circuit imprimé à l'aide d'un appareil d'impression de brasure tendre (110), un procédé de montage pour monter un composant électronique sur la carte de circuit imprimé à l'aide d'un appareil monteur (120), et un procédé de refusion pour assembler le composant électronique à la brasure tendre à l'aide d'un four de refusion (130), le système de gestion de qualité comprenant :
un appareil de détection de borne (220) configuré pour générer des informations de borne après le procédé de montage et avant le procédé de refusion en mesurant les informations de borne qui sont des informations concernant une position d'une borne du composant électronique monté sur la carte de circuit imprimé, les informations de borne étant des informations indiquant une relation de position de la borne par rapport à une position de référence établie sur le composant électronique à inspecter ; et
un appareil d'inspection de monture (230, 240) configuré pour identifier la position de la borne du composant électronique d'après les informations de borne mesurées après le procédé de refusion, identifier une zone d'inspection d'après la position de borne identifiée, et inspecter un état d'un joint à brasure tendre entre la borne et la carte de circuit imprimé dans la zone d'inspection identifiée.

2. Système de gestion de qualité selon la revendication 1, dans lequel
l'appareil de détection de borne (220) est configuré pour capturer une image du composant électronique monté sur la carte de circuit imprimé et détecter une zone comportant la borne d'après des valeurs de luminance de pixels inclus dans l'image capturée.

3. Système de gestion de qualité selon la revendication 1 ou 2, dans lequel
les informations de borne comportent des informations indiquant une position de la borne par rapport à la position de référence, une largeur de la borne et une longueur de la borne.

4. Système de gestion de qualité selon l'une quelconque des revendications 1 à 3, dans lequel
l'appareil de détection de borne (220) est au moins l'un quelconque de l'appareil monteur (120) configuré pour monter le composant électronique sur la carte de circuit imprimé, et d'un appareil d'inspection de composant (220) configuré pour inspecter un état d'agencement du composant électronique sur la carte de circuit imprimé.

5. Système de gestion de qualité selon l'une quelconque des revendications 1 à 4, dans lequel
l'appareil d'inspection de monture (230, 240) est au moins l'un quelconque d'un appareil d'inspection d'aspect (230) configuré pour inspecter un état d'un joint à brasure tendre entre une électrode sur la carte de circuit imprimé et une borne du composant électronique en utilisant une image de lumière visible, et d'un appareil d'inspection interne (240) configuré pour inspecter l'état du joint à brasure tendre entre l'électrode sur la carte de circuit imprimé et la borne du composant électronique en utilisant une image de lumière non visible.
